# FASCICULE DE BREVET EUROPEEN

(11) **EP 1 670 200 B1**
(45) Date de publication et mention de la délivrance du brevet: **29.08.2007**
(21) Numéro de dépôt: 05292283.8
(22) Date de dépôt: 27.10.2005
(51) Int. Cl.: H04L 25/49, H04L 7/02

(54) **Procédé et dispositif de génération d'horloge de décodage à partir d'un signal asynchrone de données basé sur la norme EPC global**
Verfahren und Vorrichtung zum Erzeugen eines Dekodierungstaktes aus einem asynchronen Datensignal nach der Norm EPC Global
Method and device for generating a decoding clock from an asynchronous data signal based on the EPC Global standard

(30) Priorité: 04.11.2004 FR 0411754
(43) Date de publication de la demande: 14.06.2006
(73) Titulaire: STMICROELECTRONICS SA, 92120 Montrouge (FR)
(72) Inventeur: Kari, Ahmed, 13100 Aix-en-Provence (FR); Naura, David, 13100 Aix-en-Provence (FR)
(74) Mandataire: Bentz, Jean-Paul

(56) Documents cités:
- EP-A- 0 967 562

## Description

La présente invention concerne les systèmes RFID (Radio Frequency IDentification), et en particulier le décodage des données provenant d'une étiquette électronique ou carte à puce à lecture sans contact.

Elle s'applique notamment, mais non exclusivement aux données transmises conformément à la norme EPC (Electronic Product Code^{™}).

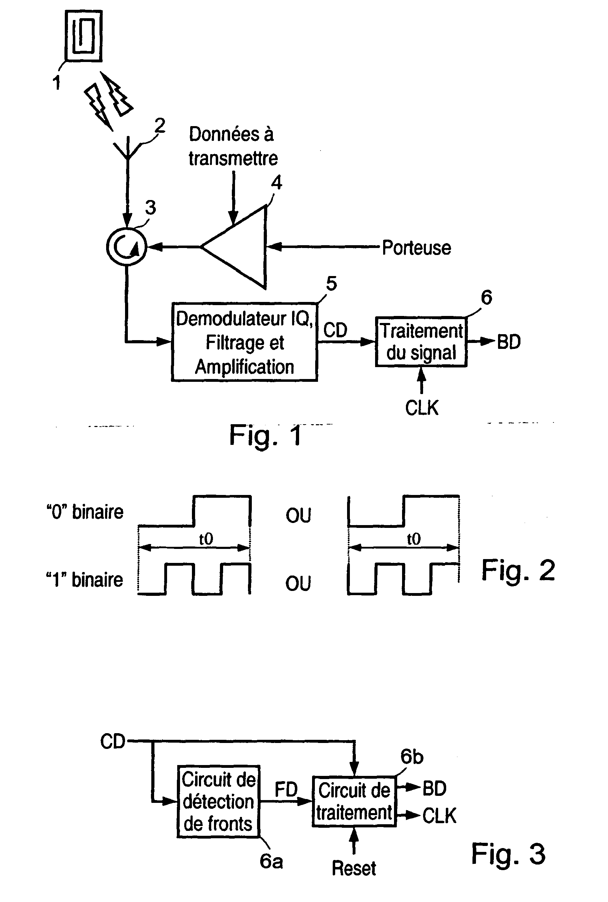

La figure 1 représente un dispositif d'émission et de réception de données échangées avec une carte à puce 1. En émission vers la carte à puce, les données à transmettre sont appliquées à un modulateur 4 recevant par ailleurs une porteuse. Selon la norme EPC Global, cette porteuse est située dans la bande UHF comprise entre 868 MHz et 925 MHz. Le signal de sortie du modulateur est appliqué à une antenne d'émission/réception 2 par l'intermédiaire d'un coupleur 3. En réception, les données transmises par la carte à puce 1 sont reçues par l'antenne 2 et appliquées par l'intermédiaire du coupleur 3 à un circuit 5 de démodulation IQ, de filtrage et d'amplification, permettant d'extraire du signal reçu l'enveloppe de la porteuse constituant les données codées. Ces données codées sont appliquées à un dispositif de décodage 6 qui délivre des données décodées.

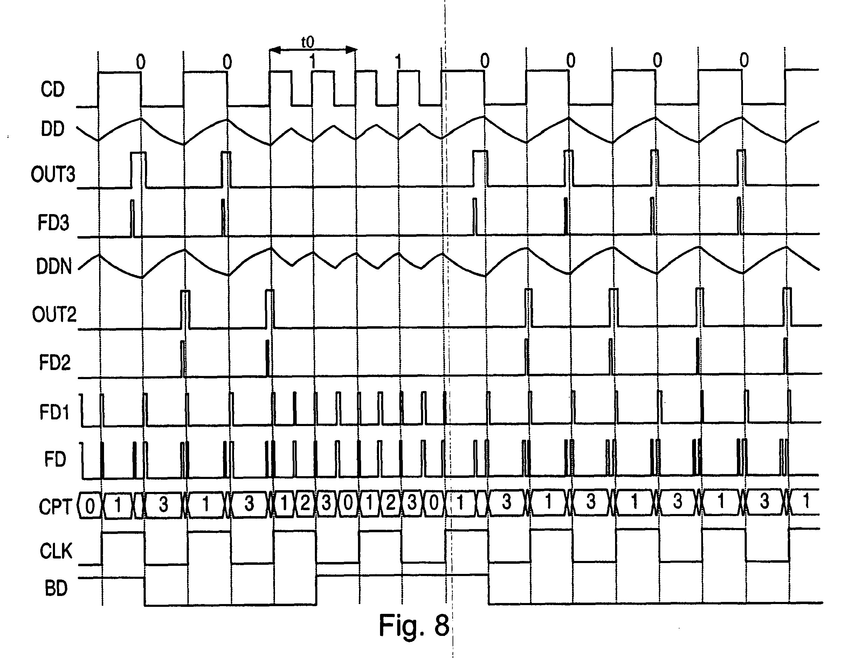

La figure 2 illustre le principe de codage des données conformément au protocole EPC Class1 - genl. Sur cette figure un "0" binaire est transmis sous la forme d'une période d'un signal carré de période t0, tandis qu'un "1" binaire est transmis sous la forme de deux périodes d'un signal carré de période t0/2 en phase avec le signal correspondant au "0" binaire. La figure 8 représente la forme d'un signal de données codées CD conformément au principe illustré par la figure 2. L'exemple de la figure 8 représente le signal de codage de la donnée binaire "00110000".

Généralement, le décodage du signal de données codées reçu, effectué par le dispositif de décodage 6 fait intervenir un microcontrôleur qui doit être piloté par un signal d'horloge CLK synchrone avec le signal de données codées reçu.

Il est connu de l'état de la technique le document EP 0967562. Dans ce document, le codage des informations est réalisé par l'utilisation de deux formes d'ondes. Chacune de ces formes d'onde possède une même période T et leur forme respective est telle qu'une transition d'état logique bas vers l'état logique haut a lieu à un temps égal à T/2. Un signal d'horloge synchrone avec les données du signal de données codées est produit par un circuit électronique détectant ces fronts montants.

La présente invention a pour but de réaliser un dispositif simplifié de décodage et de génération d'un signal d'horloge synchrone avec le signal de données. Cet objectif est atteint par la prévision d'un procédé selon la revendication 1.

Selon un mode de réalisation préféré de l'invention, les signaux de détection de fronts descendants et montants dans les données codées à 0 sont obtenus en chargeant et déchargeant des condensateurs respectifs en fonction du signal de données codées et respectivement du signal de données codées préalablement inversé, en comparant les signaux obtenus à une tension de seuil, et en détectant des fronts montant dans le signal de comparaison.

Selon un mode de réalisation préféré de l'invention, le procédé comprend en outre une étape de comptage du nombre d'impulsions dans le signal de détection de fronts, à l'aide d'un compteur 2 bits qui est initialisé à 0 au début d'une première donnée binaire du signal de données codées, le signal de données codées étant échantillonné lorsque le compteur vaut 3, le signal d'horloge généré passant à l'état haut lorsque le compteur vaut 1 et passant à l'état bas lorsque le compteur vaut 3.

L'invention concerne également un dispositif de décodage d'un signal de données binaires codées, et de génération d'un signal d'horloge synchrone avec le signal de données codées selon la revendication 5.

Selon un mode de réalisation préféré de l'invention, chacun des circuits de détection de fronts descendants et montants dans les données à 0 du signal de données codées comprennent un condensateur associé à un circuit de charge et de décharge du condensateur, en fonction du signal de données codées, un comparateur pour comparer le signal de charge et de décharge à une tension de seuil et un circuit de détection d'un front montant dans le signal de comparaison, délivrant le signal de détection de fronts descendants, et respectivement le signal de détection de fronts montants.

Selon un mode de réalisation préféré de l'invention, le circuit de charge et de décharge du condensateur de chaque circuit de détection de fronts descendants et montants dans les données à 0 du signal de données codées, comprend un ensemble de transistors montés en série, entre une source de courant constant et la masse, et commandés en fonction du signal de données codées.

Selon un mode de réalisation préféré de l'invention, le comparateur de chaque circuit de détection de fronts descendants et montants dans les données à 0 du signal de données codées, comprend plusieurs inverseurs montés en série dont les seuils de conduction sont choisis pour correspondre à la tension de seuil.

Un mode de réalisation préféré de l'invention sera décrit ci-après, à titre d'exemple non limitatif, avec référence aux dessins annexés dans lesquels :
La figure 1 représente un dispositif d'émission et de réception de données échangées avec une carte à puce RFID ;
La figure 2 illustre le principe de codage des données conformément au protocole EPC Class1 - gen1 ;
La figure 3 représente schématiquement un dispositif de décodage et de génération d'un signal d'horloge synchrone, selon l'invention ;
La figure 4 représente un premier circuit de détection de fronts du dispositif montré sur la figure 3 ;
La figure 5 montre la forme de certains signaux dans le premier circuit représenté sur la figure 4 ;
La figure 6 représente un second circuit de traitement du dispositif montré sur la figure 3 ;
La figure 7 montre plus en détail un circuit logique du circuit de traitement représenté sur la figure 6 ;
La figure 8 montre des chronogrammes de différents signaux circulant dans le dispositif représenté sur les figures 3, 4 et 6 ;
La figure 9 représente une variante du circuit de détection de fronts montré sur la figure 4.

Le procédé selon l'invention consiste tout d'abord à générer à partir du signal de données codées CD un signal FD comportant quatre impulsions par donnée du signal de données codées CD, puis à compter les impulsions pour échantillonner le signal de données codées CD toutes les quatre impulsions de manière à obtenir un signal binaire BD de données décodées, et à générer un signal d'horloge CLK synchrone avec le signal CD changeant d'état toutes les deux impulsions.

La figure 3 représente un dispositif de décodage et de génération d'un signal d'horloge synchrone, selon l'invention. Ce dispositif comprend :
- un circuit 6a de détection de fronts recevant le signal de données codées CD et délivrant le signal FD, et
- un circuit de traitement 6b recevant en entrée le signal de données codées CD, le signal FD et un signal d'initialisation Reset, et délivrant un signal BD des données binaires décodées contenues dans le signal d'entrée CD, et un signal d'horloge CLK synchrone avec le signal CD de données codées appliqué en entrée.

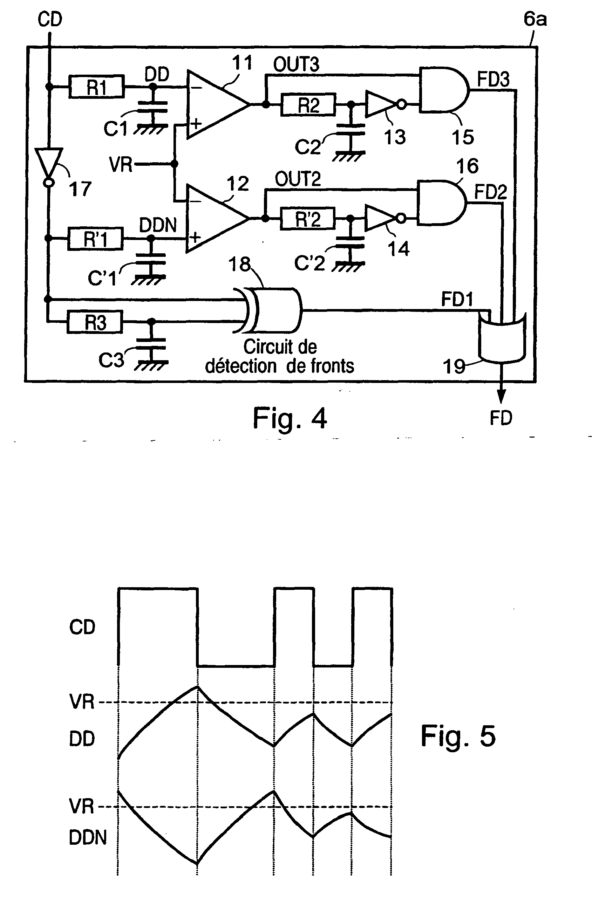

Le circuit de détection de fronts 6a représenté sur la figure 4 comprend une résistance R1 recevant le signal CD de données codées, montée en parallèle avec un condensateur C1 connecté à la masse. Le signal DD transitant au niveau du point de jonction entre la résistance R1 et le condensateur C1 est appliqué à l'entrée inverseuse d'un comparateur 11 dont l'entrée non inverseuse reçoit une tension de référence VR. Le signal de sortie OUT3 du comparateur est appliqué à une entrée d'une première porte ET 15 et traverse une résistance R2 dont l'autre borne est reliée à la masse par l'intermédiaire d'un condensateur C2, et connectée à une porte inverseuse 13. La sortie de la porte inverseuse 13 est connectée à l'autre entrée de la porte ET 15 qui délivre un premier signal FD3 de détection de fronts.

Le signal de données codées CD est également appliqué à une porte inverseuse 17 dont la sortie est connectée à une résistance R'1 montée en parallèle avec un condensateur C1 connecté à la masse. Le signal DDN transitant au niveau du point de jonction entre la résistance R'1 et le condensateur C'1 est appliqué à l'entrée non inverseuse d'un comparateur 12 dont l'entrée inverseuse reçoit la tension de référence VR. Le signal de sortie OUT2 du comparateur 12 est appliqué à une entrée d'une porte ET 16 et traverse une résistance R'2 dont l'autre borne est reliée à la masse par l'intermédiaire d'un condensateur C'2, et connectée à une porte inverseuse 14. La sortie de la porte inverseuse 14 est connectée à l'autre entrée de la porte ET 16 qui délivre un second signal FD2 de détection de fronts.

Par ailleurs, la sortie de la porte inverseuse 17 est connectée à l'entrée d'une porte OU EXCLUSIF 18, ainsi qu'à une résistance R3 dont l'autre borne est connectée à l'autre entrée de la porte 18 et à la masse par l'intermédiaire d'un condensateur C3. La porte 18 délivre un troisième signal FD1 de détection des deux (pour un "0" binaire) ou quatre (pour un "1" binaire) fronts montants de chaque donnée codée.

Le signal FD1 est appliqué avec les signaux FD2 et FD3 à l'entrée d'une porte OU 19 qui délivre un signal de détection de fronts FD comportant 4 impulsions pour chaque donnée codée.

La valeur des résistances R1 et R'1, et la valeur des condensateurs C1 et C'1 sont choisies de manière à ce que la constante de temps R1·C1 = R'1·C'1 soit égale à t0/4, t0 étant la période d'une donnée élémentaire dans le signal de données codées, comme représenté sur les figures 2 et 8. Ainsi, si t0 = 8 µs (cas de la norme Européenne de EPC), R1 = R'1 = 200 kΩ et C1= C'1 = 10 pF. La tension de référence VR est choisie de manière à générer en sortie des deux comparateurs 11 et 12, comme illustré sur les figures 5 et 8 :
- aucune impulsion si la donnée codée correspond à un "1" binaire,
- une impulsion par donnée codée correspondant à un "0" binaire pour le comparateur 11, et
- une impulsion par donnée codée correspondant à un "0" binaire pour le comparateur 12.

Comme on peut le voir sur la figure 8 qui montre le chronogramme des signaux CD, DD, OUT3 et FD3, DDN, OUT2, FD2, FD1 et FD mentionnés ci-avant, le signal FD3 présente une impulsion par front descendant de donnée égale à 0 dans le signal de données codées CD. Le signal FD2 présente une impulsion par front montant de donnée égale à 0 dans le signal de données codées CD. Le signal FD1 présente une impulsion par front montant et descendant dans le signal de données codées CD. Et enfin, le signal FD qui correspond à la somme des signaux FD1, FD2 et FD3, comporte 4 impulsions pour chaque donnée codée, à savoir pour les données égales à 0, une impulsion fournie par chacun des signaux FD2 et FD3 et deux impulsions fournies par le signal FD1. Les quatre impulsions pour les données égales à 1 sont fournies par le signal FD1.

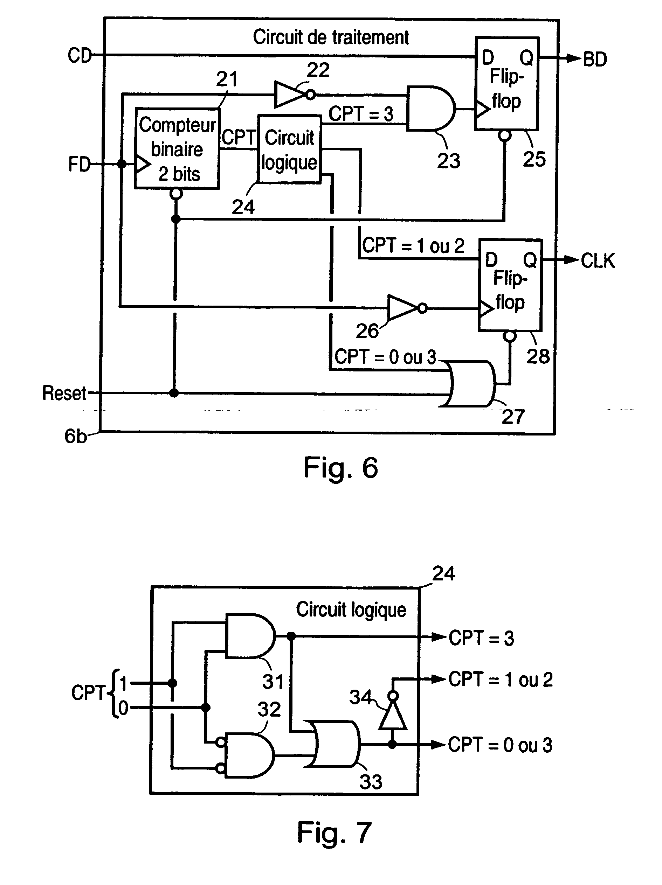

Le circuit de traitement 6b montré sur la figure 6 comprend un compteur binaire 21 à deux bits qui reçoit le signal FD et dont la sortie est connectée à un circuit logique 24 comportant trois sorties dont les valeurs respectives dépendent de la valeur du compteur 21. Une première sortie du circuit logique qui délivre un signal logique à 1 si la valeur du compteur est égale à 3, est connectée à une porte ET 23 qui reçoit sur son autre entrée le signal FD inversé par une porte inverseuse 22. La sortie de la porte ET 23 est connectée à l'entrée de signal d'horloge d'une bascule D 25 recevant par ailleurs sur son entrée D le signal de données codées CD et délivrant sur sa sortie Q le signal de données binaires BD des données décodées.

Une seconde sortie du circuit logique 24 qui délivre un signal logique à 1 si la valeur du compteur est égale à 1 ou 2, est connectée à l'entrée de D d'une bascule D 28 recevant par ailleurs sur son entrée de signal d'horloge le signal FD inversé par une porte inverseuse 26, et délivrant sur sa sortie Q le signal d'horloge CLK synchrone avec le signal CD de données codées.

Les entrées de remise à zéro du compteur binaire 21 et de la bascule 25 sont connectées à une entrée de signal Reset du circuit de traitement 6.

Une troisième sortie du circuit logique 24 qui délivre un signal logique à 1 si la valeur du compteur est égale à 0 ou 3, est connectée à une entrée d'une porte OU 27 dont l'autre entrée est connectée à l'entrée de signal Reset du circuit. La sortie de la porte OU 27 est connectée à l'entrée de remise à zéro de la bascule 28.

Le principe de fonctionnement du circuit représenté sur la figure 6 est illustré sur la figure 8. Au début de la lecture de la carte à puce 1, le circuit est initialisé par le signal Reset à 0. La valeur CPT du compteur binaire 21 est alors à "000", tandis que la sortie Q des bascules est à 0. Dès qu'un signal CD est reçu de la carte à puce, le signal Reset passe à 1 et le compteur se met à compter les impulsions (fronts montants) du signal FD. Lorsque la valeur CPT du compteur atteint "011" (3), le signal provenant de la carte à puce est échantillonné par la bascule 25 sur un front descendant du signal FD, ce qui correspond au décodage binaire du signal de données codées CD.

Lorsque la valeur CPT du compteur atteint la valeur "001 " (1) ou "010" (2), le signal d'horloge CLK passe à 1 et pour toutes les autres valeurs du compteur, ce signal passe à 0. Le signal d'horloge CLK ainsi généré est un signal carré de fréquence 1/t0, synchrone avec les fronts (fronts montants et descendants des données à 0 et fronts montants des données à 1) du signal de données codées CD.

Comme le signal d'horloge CLK est généré à partir du signal de données codées CD, on est assuré que ces deux signaux sont toujours strictement en phase, même si le signal CD à traiter comporte de légères variations de phase ou de fréquence. Il n'est pas possible d'atteindre un tel résultat avec une boucle à verrouillage de phase.

Sur la figure 7 qui montre un exemple de réalisation du circuit logique 24, ce circuit reçoit en entrée les bits 0 et 1 du compteur binaire 21. Le signal logique à 1 si la valeur du compteur est égale à 3 est obtenu à l'aide d'une porte ET 31 recevant en entrée les bits 0 et 1 du compteur binaire 21.

Le signal logique à 1 si la valeur du compteur est égale à 0 ou 3 est obtenu à l'aide de la porte ET 31, d'une porte ET 32 à entrées inversées, et d'une porte OU 33 délivrant le signal recherché. La porte ET 32 qui reçoit en entrée les bits 0 et 1 du compteur binaire 21. Les sorties des portes ET 31, 32 sont connectées aux entrées de la porte OU 33.

Le signal logique à 1 si la valeur du compteur est égale à 1 ou 2 est obtenu à l'aide d'une porte inverseuse 34 qui inverse le signal en sortie de la porte OU 33.

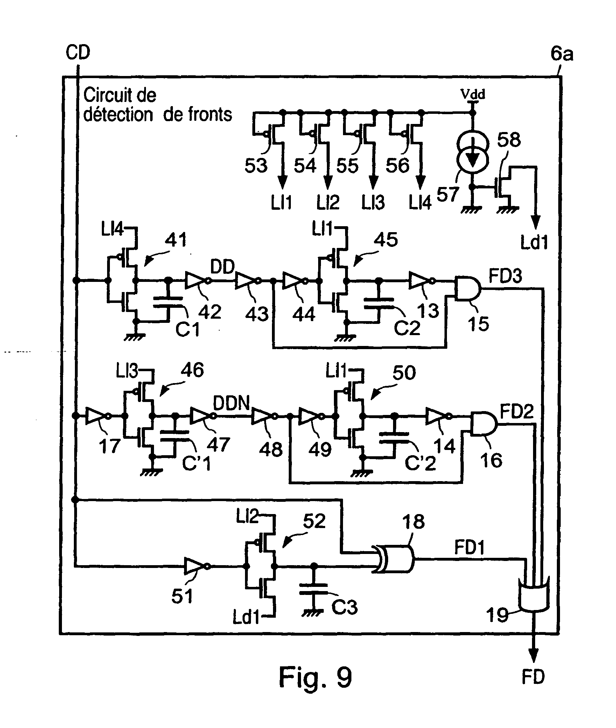

La figure 9 montre une variante du circuit de détection de fronts représenté sur la figure 4. Dans ce circuit, les résistances des ensembles RC du circuit de la figure 4 ont été remplacées par un ensemble de deux transistors MOS, relié à une source de courant, et chacun des comparateurs 11, 12 par un ensemble de trois portes inverseuses en série dont les seuils dépendent de la taille des transistors avec lesquels elles sont constituées.
Chaque ensemble de transistors MOS comprend un transistor PMOS monté en série avec un transistor NMOS, la source du transistor PMOS étant reliée à une source de courant, tandis que la source du transistor NMOS est connectée à la masse. Les grilles et les drains des deux transistors étant interconnectés et constituant respectivement l'entrée de l'ensemble et la sortie de l'ensemble.

Plus précisément, la résistance R1 du circuit représenté sur la figure 4 est remplacée dans la figure 9 par un ensemble de transistors 41 dont la source du transistor PMOS est connectée à une source de courant L14. Le comparateur 11 est remplacé par un ensemble de trois portes inverseuses 42, 43, 44, la sortie de la porte 43 étant connectée à l'entrée de la porte ET 15. La résistance R2 est remplacée par un ensemble de transistors 45, dont la source du transistor PMOS est connectée à une source de courant L11. La résistance R'1 est remplacée par un ensemble de transistors 46 dont la source du transistor PMOS est connectée à une source de courant L13. Le comparateur 12 est remplacé par un ensemble de trois portes inverseuses 47, 48, 49, la sortie de la porte 48 étant connectée à l'entrée de la porte ET 16. La résistance R'2 est remplacée par un ensemble de transistors 50, dont la source du transistor PMOS est connectée à la source de courant L11. La résistance R3 est remplacée par un ensemble de transistors 52, dont la source du transistor PMOS est connectée à une source de courant L12, et la source du transistor NMOS est reliée à une source de courant Ld1. L'entrée du signal de données codées CD est reliée à la grille des deux transistors de l'ensemble 52 par l'intermédiaire d'une porte inverseuse 51, et connectée directement à l'entrée de la porte OU Exclusif 18. Les courants L11, L12, L13 et L14 sont générés à l'aide d'une source de tension Vdd et d'une source de courant 57 et de transistors PMOS 53, 54, 55, 56 respectifs montés en parallèle, la source et la grille de ces transistors étant connectées au point de jonction entre la source de tension et la source de courant 57, le drain de ces transistor fournissant le courant correspondant L11, L12, L13 et L14 dépendant de la taille des transistors respectifs. L'autre borne de la source de courant 57 est connectée à la masse et à la grille d'un transistor NMOS 58 dont la source est connectée à la masse et dont le drain fournit le courant Ld1.

Le circuit 6a représenté sur la figure 9 présente l'avantage de supprimer les résistances dont les valeurs varient en fonction de la température, et de ne faire intervenir que des composants facilement intégrables dans un circuit intégré.

## Revendications

1. Procédé pour décoder un signal de données binaires codées (CD) et pour générer un signal d'horloge (CLK) synchrone avec le signal de données codées, dont une première valeur binaire est transmise sous la forme d'une période d'un signal carré de période t0, tandis qu'une deuxième valeur binaire est transmise sous la forme de deux périodes d'un signal carré de période t0/2 en phase avec le signal correspondant à la première valeur binaire, ,
**caractérisé en ce qu'**il comprend des étapes consistant à :
- générer à partir du signal de données codées (CD) un signal de détection de fronts FD comportant quatre impulsions par état binaire du signal de données codées, et généré à partir d'un signal FD1 de détection de fronts montants et descendants dans le signal de données codées (CD), et de deux signaux FD2 et FD3 de détection de fronts montants et descendants dans les données à 0 du signal de données codées
- échantillonner le signal de données codées toutes les quatre impulsions du signal de détection de fronts FD, de manière à obtenir un signal binaire (BD) de données décodées, et
- générer à partir du signal de détection de fronts FD, un signal binaire d'horloge (CLK) synchrone avec le signal de données codées (CD), présentant un changement d'état logique toutes les deux impulsions du signal de détection de fronts FD.

2. Procédé selon la revendication 1,
**caractérisé en ce que** les signaux FD3 et FD2 de détection de fronts descendants et montants dans les données codées à 0 sont obtenus en chargeant et déchargeant des condensateurs (C1, C'1) respectifs en fonction du signal de données codées (CD) et respectivement du signal de données codées (CD) préalablement inversé, en comparant les signaux obtenus à une tension de seuil (VR), et en détectant des fronts montants dans le signal de comparaison.

3. Procédé selon l'une des revendications 1 à 2,
**caractérisé en ce qu'**il comprend en outre une étape de comptage du nombre d'impulsions dans le signal de détection de fronts FD, à l'aide d'un compteur 2 bits (21) qui est initialisé à 0 au début d'une première donnée binaire du signal de données codées, le signal de données codées (CD) étant échantillonné lorsque le compteur vaut 3, le signal d'horloge (CLK) généré passant à l'état haut lorsque le compteur vaut 1 et passant à l'état bas lorsque le compteur vaut 3.

4. Procédé selon l'une des revendications 1 à 3,
**caractérisé en ce que** le signal FD, est généré pour les données égales à 0, par une impulsion fournie par chacun des signaux FD2 et FD3 et deux impulsions fournies par le signal FD1, et pour les données égales à 1, par quatre impulsions fournies par le signal FD1.

5. Dispositif de décodage d'un signal de données binaires codées (CD), et de génération d'un signal d'horloge (CLK) synchrone avec le signal de données codées, dont la première valeur binaire est transmise sous la forme d'une période d'un signal carré de période t0, tandis que la deuxième valeur binaire est transmise sous la forme de deux périodes d'un signal carré de période t0/2 en phase avec le signal correspondant à la première valeur binaire, **caractérisé en ce qu'**il comprend un circuit (6a) de détection de fronts dans le signal de données codées (CD), conçu pour générer un signal de détection de fronts FD comportant quatre impulsions par état binaire du signal de données codées, et un circuit (6b) d'échantillonnage du signal de données codées, conçu pour échantillonner le signal de données codées toutes les quatre impulsions du signal de détection de fronts, de manière à obtenir un signal binaire (BD) de données décodées, et conçu pour générer à partir du signal de détection de fronts, un signal binaire d'horloge (CLK) synchrone avec le signal de données codées (CD), présentant un changement d'état logique toutes les deux impulsions du signal de détection de fronts, ledit circuit (6a) de détection de fronts comprenant un circuit (R3, C3, 18) de détection de fronts montants et descendants dans le signal de données codées (CD) produisant un premier signal de détection de fronts FD1, un circuit (17, R'1, C'1, 12, R'2, C'2, 14, 16) de détection de fronts montants dans les données à 0 du signal de données codées, et produisant un second signal de détection de fronts FD2, et un circuit de détection (R1, C1, 11, R2, C2, 13, 15) de fronts descendants dans les données à 0 du signal de données codées, et produisant un troisième signal de détection de fronts FD3.

6. Dispositif selon la revendication 5,
**caractérisé en ce que** chacun des circuits de détection de fronts descendants et montants dans les données à 0 du signal de données codées (CD) comprennent un condensateur (C1, C'1) associé à un circuit de charge et de décharge du condensateur, en fonction du signal de données codées, un comparateur (11, 12) pour comparer le signal de charge et de décharge à une tension de seuil (VR) et un circuit de détection d'un front montant dans le signal de comparaison, délivrant le signal FD3 de détection de fronts descendants, et respectivement le signal FD2 de détection de fronts montants.

7. Dispositif selon la revendication 5,
**caractérisé en ce que** le circuit de charge et de décharge du condensateur (C1, C'1) de chaque circuit de détection de fronts descendants et montants dans les données à 0 du signal de données codées (CD), comprend un ensemble de transistors montés en série, entre une source de courant (L13, L14) constant et la masse, et commandés en fonction du signal de données codées (CD).

8. Dispositif selon la revendication 6 ou 7,
**caractérisé en ce que** le comparateur de chaque circuit de détection de fronts descendants et montants dans les données à 0 du signal de données codées (CD), comprend plusieurs inverseurs (42 à 44, 47 à 49) montés en série dont les seuils de conduction sont choisis pour correspondre à la tension de seuil (VR).

9. Dispositif selon l'une quelconque des revendications 5 à 8, dans lequel le signal FD, comprend, pour les données égales à 0, une impulsion fournie par chacun des signaux FD2 et FD3 et deux impulsions fournies par le signal FD1, et pour les données égales à 1, quatre impulsions fournies par le signal FD1.

## Claims

1. Method for decoding a signal (CD) of encoded binary data and for generating a clock signal (CLK) synchronous with the encoded data signal, of which a first binary value is transmitted in the form of one period of a square wave signal with a period t0 whereas a second binary value is transmitted in the form of two periods of a square wave signal with a period t0/2 in phase with the signal corresponding to the first binary value,
**characterised in that** it includes steps consisting of:
- generating, from the encoded data signal (CD), an edge detection FD signal comprising four pulses per binary state of the encoded data signal and generated from a signal FD1 for detecting rising and falling edges in the encoded date signal (CD), and two signals FD2, FD3 for detecting a rising and a falling edges in the data at 0 of the encoded data signal.
- sampling the encoded data signal every four pulses of the edge detection signal FD, so as to obtain a binary signal (BD) of decoded data, and
- generating, from the edge detection signal FD, a binary clock signal (CLK) synchronous with the encoded data signal (CD), having a change in logic state every two pulses of the edge detection signal FD.

2. Method according to claim 1, **characterised in that** the signals FD3, FD2 for detecting falling and rising edges in the encoded data at 0 are obtained by charging and discharging respective capacitors (C1, C'1) according to the encoded data signal (CD) and the encoded data signal (CD) which has been previously inverted, respectively, by comparing the signals obtained with a threshold voltage (VR), and by detecting rising edges S in the comparison signal.

3. Method according to one of claims 1 to 2, **characterised in that** it also includes a step of counting the number of pulses in the edge detection signal FD, using a 2-bit counter (21) which is set to 0 at the beginning of a first binary data item of the encoded data signal, wherein the encoded data signal (CD) is sampled when the counter reaches 3, and the generated clock signal (CLK) switches to high level when the counter is at 1 and switches to low level when the counter is at 3.

4. Method according to one of claims 1 to 3, **characterized in that** the signal FD is generated for the data equal to 0, by one pulse supplied by each of signals FD2 and FD3, and two pulses supplied by signal FD1, and for the data equal to 1, by four pulses supplied by signal FD1.

5. Device for decoding an encoded binary data signal (CD), and for generating a clock signal (CLK) synchronous with the encoded data signal, of which the first binary value is transmitted in the form of one period of a square wave signal with a period t0 whereas the second binary value is transmitted in the form of two periods of a square wave signal with a period t0/2 in phase with the signal corresponding to the first binary value,
**characterised in that** it includes a circuit (6a) for detecting edges in the encoded data signal (CD), designed to generate an edge detection signal FD comprising four pulses per binary state of the encoded data signal, and a circuit (6b) for sampling the encoded data signal, designed to sample the encoded data signal every four pulses of the edge detection signal, so as to obtain a binary signal (BD) of decoded data, and designed to generate, from the edge detection signal, a binary clock signal (CLK) synchronous with the encoded data signal (CD), having a change in logic state every two pulses of the edge detection signal, said edge detection circuit (6a) including a circuit (R3, C3, 18) for detecting rising and falling edges in the encoded data signal (CD) producing a first edge detection signal FD1, a circuit (17, R'1, C'1, 12, R'2, C'2, 14, 16) for detecting rising edges in the data at 0 of the encoded data signal, and producing a second edge detection signal FD2, and a circuit (R1, C1, 11, R2, C2, 13, 15) for detecting falling edges in the data at 0 of the encoded data signal, and producing a third edge detection signal FD3.

6. Device according to claim 5, **characterised in that** each of the circuits for detecting falling and rising edges in the data at 0 of the encoded data signal (CD) includes a capacitor (C1, C'1) associated with a circuit for charging and discharging the capacitor, according to the encoded data signal, a comparator (11, 12) for comparing the charging and discharging signal to a threshold voltage (VR) and a circuit for detecting a rising edge in the comparison signal, delivering the signal FD3 detecting falling edges, and the signal FD2 detecting rising edges, respectively.

7. Device according to claim 6, **characterised in that** the capacitor (C1, C'1) charging and discharging circuit of each circuit for detecting falling and rising edges in the data at 0 of the encoded data signal (CD), includes an assembly of transistors connected in series, between a constant current source (L13, L14) and the ground, and controlled according to the encoded data signal (CD).

8. Device according to claim 6 or 7, **characterised in that** the comparator of each circuit for detecting falling and rising edges in the data at 0 of the encoded data signal (CD) includes a plurality of invertors (42 to 44, 47 to 49) connected in series, of which the conduction thresholds are selected so as to correspond to the threshold voltage (VR).

9. Device according to any one of claims 5 to 8, in which signal FD comprises, for the data equal to 0, one pulse supplied by each of signals FD2 and FD3, and two pulses supplied by signal FD1, and for the data equal to 1, four pulses supplied by signal FD1.

## Patentansprüche

1. Verfahren zum Dekodieren eines kodierten, binären Datensignals (CD) und zum Erzeugen eines Taktsignals (CLK), das zu dem kodierten Datensignal synchron ist, dessen erster binärer Wert in Form einer Periode eines periodischen Rechtecksignals t0 übertragen wird, während ein zweiter binärer Wert in Form zweier Perioden eines periodischen Rechtecksignals t0/2 phasengleich zu dem entsprechenden Signal mit dem ersten binären Wert übertragen wird,
**dadurch gekennzeichnet, daß**:
- aus dem kodierten Datensignal (CD) ein Flankendetektionssignal FD erzeugt wird, das vier Impulse pro binären Zustand des kodierten Datensignals umfaßt und aus einem Detektionssignal FD1 für steigende und fallende Flanken in dem kodierten Datensignal (CD) und zwei Detektionssignale FD2 und FD3 für steigende und fallende Flanken S bei den Daten mit Wert 0 des kodierten Datensignals erzeugt wird,
- das kodierte Datensignal nach jeweils vier Impulsen des Flankendetektionssignals FD abgetastet wird, um ein Binärsignal (BD) von dekodierten Daten zu erhalten, und
- aus dem Flankendetektionssignal FD ein binäres Taktsignal (CLK) erzeugt wird, das zu dem kodierten Datensignal (CD) synchron ist, das einen Wechsel des logischen Zustandes alle zwei Impulse des Flankendetektionssignals FD aufweist.

2. Verfahren nach Anspruch 2,
**dadurch gekennzeichnet, daß** die Detektionssignale FD3 und FD2 für fallende und steigende Flanken S bei den als 0 kodierten Daten durch Laden und Entladen von jeweiligen Kondensatoren (C1, C'1) in Abhängigkeit des kodierten Datensignals (CD) beziehungsweise des vorher invertierten Datensignals (CD) erhalten werden, indem die erhaltenen Signale mit einer Schwellspannung (VR) verglichen werden, und indem steigende Flanken S in dem Vergleichssignal detektiert wird.

3. Verfahren nach einem der Ansprüche 1 bis 2,
**dadurch gekennzeichnet, daß** die Anzahl der Impulse in dem Flankendetektionssignal FD mit Hilfe eines 2-Bit-Zählers (21) gezählt wird, der mit 0 am Anfang eines ersten binären Werts des kodierten Datensignals initialisiert wird, wobei das kodierte Datensignal (CD) abgetastet wird, wenn der Zähler den Wert 3 hat, wobei das erzeugte Taktsignal (CLK) in den oberen Zustand übergeht, wenn der Zähler den Wert 1 hat, und den tiefen Zustand übergeht, wenn der Zähler den Wert 3 hat.

4. Verfahren nach einem der Ansprüche 1 bis 3,
**dadurch gekennzeichnet, daß** das Signal FD für Daten mit Wert gleich 0 durch einen Impuls, der durch jedes der Signale FD2 und FD3 geliefert wird, und durch zwei durch das Signal FD1 gelieferte Impulse und für Daten mit Wert gleich 1 durch vier durch das Signal FD1 gelieferte Impulse erzeugt wird.

5. Vorrichtung zur Dekodierung eines kodierten, binären Datensignals (CD) und zur Erzeugung eines Taktsignals (CLK), das zu dem kodierten Datensignal synchron ist, wobei der erster binärer Wert des kodierten Datensignals in Form einer Periode eines periodischen Rechtecksignals t0 übermittelt wird, während der zweite binäre Wert in Form zweier Perioden eines periodischen Rechtecksignals t0/2 übermittelt wird, die phasengleich mit dem entsprechendem Signal des ersten binären Werts ist, **gekennzeichnet durch** einen Schaltkreis (6a) zur Detektion von Flanken von dem kodierten Datensignal (CD), der ausgebildet ist, um ein Flankendetektionssignal FD zu erzeugen, das vier Impulse pro Binärzustand des kodierten Datensignals umfaßt, und einen Schaltkreis (6b) zum Abtasten des kodierten Datensignals, der ausgebildet ist, um das kodierte Datensignal alle vier Impulse des Flankendetektionssignals abzutasten, um ein binäres Signal (BD) der dekodierten Daten zu erhalten, und ausgebildet ist, um von dem Flankendetektionssignal ein binäres Taktsignal (CLK) zu erzeugen, das synchron mit den kodierten Datensignal (CD) ist, das einen Wechsel des logischen Zustands alle zwei Impulse des Flankendetektionsignals aufweist, wobei der Schaltkreis (6a) zur Detektion von Flanken einen Schaltkreis (R3, C3, 18) zur Detektion von steigenden und fallenden Flanken von dem kodierten Datensignals (CD), um ein erstes Signal der Detektion von Flanken FD1 zu erzeugen, einen Schaltkreis (17, R'1, C'1, 12, R'2, C'2, 14, 16) zur Detektion von steigenden Flanken bei Daten mit Wert 0 des kodierten Datensignals, der ein zweites Signal der Detektion von Flanken FD2 erzeugt, und einen Schaltkreis zur Detektion (R1, C1, 11, R2, C2, 13, 15) für fallende Flanken bei Daten mit Wert 0 des kodierten Datensignals umfaßt, der ein drittes Signal der Detektion von Flanken FD3 erzeugt.

6. Vorrichtung nach Anspruch 5,
**dadurch gekennzeichnet, daß** jeder der Schaltkreise zur Detektion von fallenden und steigenden Flanken bei den Daten mit Wert 0 des kodierten Datensignals (CD) einen Kondensator (C1, C'1), der in Funktion des kodierten Datensignals an einen Ladeund Entladeschaltkreis für den Kondensator geschaltet ist, einen Komparator (11, 12), um das Ladesignal und das Entladesignal mit einer Schwellspannung (VR) zu vergleichen, und einen Schaltkreis zur Detektion einer steigenden Flanke in dem Vergleichssignal umfaßt, wobei das Signal FD3 der Detektion von fallenden Flanken und entsprechend das Signal FD2 der Detektion von steigenden Flanken geliefert wird.

7. Vorrichtung nach Anspruch 5,
**dadurch gekennzeichnet, daß** der Lade- und Entladeschaltkreis des Kondensators (C1, C'1) jedes Schaltkreises zur Detektion von fallenden oder steigenden Flanken bei den Daten mit Wert 0 des kodierten Datensignals (CD) einen Aufbau von in Reihe geschalteten Transistoren zwischen einer Gleichstromquelle (L13, L14) und der Masse umfaßt, die in Funktion der kodierten Datensignale (CD) gesteuert werden.

8. Vorrichtung nach Anspruch 6 oder 7,
**dadurch gekennzeichnet, daß** der Komparator jedes Schaltkreises zur Detektion von fallenden und steigenden Flanken von den Daten mit Wert 0 des kodierten Datensignals (CD) mehrere in Reihe geschalte Invertierer (42 bis 44, 47 bis 49) umfaßt, deren Leitschwellwerte gewählt sind, um einer Schwellspannung (VR) zu entsprechen.

9. Vorrichtung nach einem der Ansprüche 5 bis 8, bei dem das Signal FD für die Daten mit Wert 0 ein durch jedes der Signale FD2 und FD3 gelieferten Impuls und zwei durch das Signal FD1 gelieferte Impulse und für die Daten mit Wert 1 vier durch das Signal FD1 gelieferte Impulse umfaßt.
